# EUROPÄISCHE PATENTSCHRIFT

(11) **EP 3 679 601 B1**
(45) Veröffentlichungstag und Bekanntmachung des Hinweises auf die Patenterteilung: **08.09.2021**
(21) Anmeldenummer: 18810942.5
(22) Anmeldetag: 19.11.2018
(51) Int. Cl.: H01L 23/367, H01L 23/40

(54) **HALBLEITERBAUGRUPPE**
SEMICONDUCTOR MODULE
MODULE SEMI-CONDUCTEUR

(30) Priorität: 29.12.2017 EP 17211136
(43) Veröffentlichungstag der Anmeldung: 15.07.2020
(73) Patentinhaber: Siemens Aktiengesellschaft, 80333 München (DE)
(72) Erfinder: PFEFFERLEIN, Stefan, 90562 Heroldsberg (DE); BIGL, Thomas, 91074 Herzogenaurach (DE); OCHS, Ewgenij, 90765 Fürth (DE)
(86) Internationale Anmeldenummer: PCT/EP2018/081734
(87) Internationale Veröffentlichungsnummer: WO 2019/129421

(56) Entgegenhaltungen:
- EP-A1- 1 420 445
- EP-A1- 2 838 326
- DE-A1-102015 213 495

## Beschreibung

Die Erfindung betrifft eine Halbleiterbaugruppe, welche ein Halbleiterelement mit ersten Kontakten, ein Trägerelement mit zweiten Kontakten und einen Kühlkörper umfasst. Ferner betrifft die Erfindung einen Umrichter mit der Halbleiterbaugruppe und ein Herstellungsverfahren für den Kühlkörper der Halbleiterbaugruppe.

Eine zum Stand der Technik gehörende Halbleiterbaugruppe wird in der EP 1 420 445 A1 veröffentlicht am 19. Mai 2004 beschrieben.

Zur Entwärmung von Halbleiterelementen, z.B. von Leistungshalbleiterschaltern in Form von IGBTs (Insulated-Gate Bipolar Transistor) oder MOS-FETs (Metal-Oxide Semiconductor Field Effect Transistor), welche im Allgemeinen auf einem Trägerelement, meist einer elektrischen Leiterplatte aus Kunststoff, elektrisch kontaktiert sind, werden diese Halbleiterelemente in der Regel über ein Keramiksubstrat mit einem Kühlkörper mechanisch verbunden. Dieser konstruktive Aufbau kann auch als Halbleiterbaugruppe bezeichnet werden.

Derartige Halbleiterbaugruppen kommen insbesondere in Umrichtern elektrischer Antriebssysteme bzw. in Umrichtern von Energieversorgungssystemen zum Einsatz.

Die elektrische Kontaktierung des Halbleiterelements mit dem Trägerelement für die Halbleiterbaugruppe erfolgt dabei oftmals mittels z.B. einer Lötverbindung oder auch einer Sinterverbindung. Die Herstellung der elektrischen Kontaktierung des Halbleiterelements mit dem Trägerelement hat meist aus Sicht des thermischen und des elektrischen Aufbaus der Halbleiterbaugruppe erhebliche Deformationen sowohl am Halbleiterelement wie auch am Trägerelement zur Folge.

Die während des Herstellungsvorgangs auftretende Wärmeentwicklung bei der Erzeugung der Lötverbindung bzw. der Sinterverbindung, sowie die nachfolgende Abkühlung auf eine Umgebungs- bzw. Raumtemperatur, lassen diese Deformationen aufgrund des unterschiedlichen thermischen Ausdehnungskoeffizienten des Halbleiterelements und des Trägerelement, welche über elektrischen Kontakte mittels der Lötverbindung bzw. der Sinterverbindung zwangsgeführt miteinander mechanisch verbunden sind, entstehen.

So kann beispielsweise das Trägerelement im Zuge der Wärmezufuhr während des Lötvorgangs mehr deformiert werden, als das Halbleiterelement, wobei durch diese unterschiedlichen Deformationsvorgänge nach der Abkühlung auf beispielsweise die Umgebungstemperatur eine vollständige Rückbildung der Deformation des Halbleiterelements verhindert wird.

Diese Deformationsvorgänge treten demzufolge insbesondere beim direkten stoffschlüssigen Verbinden unter Temperatureinwirkung auf, wie dies abweichend zur späteren Betriebstemperatur beispielsweise beim Löten von elektrischen Flachbaugruppen der Fall ist.

So zeigen sich diese Deformationen dann oftmals in Form von Wölbungen an den Oberflächen einerseits des Halbleiterelements, z.B. an einer Oberfläche eines Keramiksubstrats, mittels dem das Halbleiterelement mit einer Oberfläche des Kühlkörper verbunden wird, und andererseits an den Oberflächen des Trägerelements.

Ein bisher noch unzureichend gelöstes Problem besteht darin, dass z.B. die mechanische/thermische Verbindung des Halbleiterelements mit dem Kühlkörper über die gesamten, für die thermische Verbindung relevanten Oberflächen der beiden Bauelemente möglichst planparallel und formschlüssig insbesondere dann verfügbar soll, wenn das Halbleiterelement Betriebszustände erreicht, welche eine maximale Wärmeabfuhr vom Halbleiterelement zum Kühlkörper erfordern.

Die unerwünschten Ausprägungen der genannten temperaturabhängigen Deformationen bzw. Wölbungen lassen sich heute nur mittels aufwändiger und kostenintensiver Maßnahmen, wie z.B. durch Materialkombinationen des Halbleiterelements und des Trägerelements, durch Ausgleichsschichten zwischen den mechanischen und elektrischen Verbindungen und durch ein optimales Verhältnis von Füge- zu Betriebstemperatur der genannten elektrischen Bauelemente für die Herstellung der mechanischen und elektrischen Verbindungen, zumindest teilweise beeinflussen. Trotz dieser Maßnahmen lässt es sich oftmals nicht verhindern, dass die mechanische/thermische Verbindung des Halbleiterelements mit dem Kühlkörper bei den für eine Entwärmung besonders kritischen Betriebszuständen nur punktuell an einigen Stellen der beiden relevanten Oberflächen dieser Bauelemente erfolgt.

Der Erfindung liegt daher die Aufgabe zugrunde, eine Halbleiterbaugruppe insbesondere auch für einen Umrichter bereitzustellen, bei der eine mechanisch/thermische Verbindung von einem Halbleiterelement der Halbleiterbaugruppe mit einem Kühlkörper der Halbleiterbaugruppe bei ausgewählten Betriebszuständen des Halbleiterbauelements formschlüssig möglichst über die gesamten thermisch relevanten Oberflächen der Bauelemente erfolgt, und ein Herstellungsverfahren des Kühlkörper für die Halbleiterbaugruppe bereitzustellen, welches aufwandsarm und kostengünstig ist.

Die Aufgabe wird durch eine Halbleiterbaugruppe mit den in Anspruch 1 angegebenen Merkmalen gelöst. Ferner wird die Aufgabe durch einen Umrichter nach Anspruch 7 und ein Herstellungsverfahren nach Anspruch 8 gelöst.

Der Erfindung liegt unter anderem die Erkenntnis zugrunde, dass in der Regel der thermische Ausdehnungskoeffizient eines Halbleiterelements kleiner ist, als beispielsweise der einer Leiterplatte als Trägerelement des Halbleiterelements. Für schaltbare Leistungshalbleiterelemente werden beispielsweise meist Keramiksubstrate zur elektrischen Isolation gegenüber dem Kühlkörper verwendet und bilden somit einen wesentlichen thermischen Übergang zum Kühlkörper.

Die oftmals sehr unterschiedlichen thermischen Ausdehnungskoeffizienten des Keramiksubstrats des Halbleiterelements und des Trägerelements sind demnach eine maßgelbliche Ursache dafür, dass meist unabhängig von den konkreten Betriebszuständen des Halbleiterelements eine Deformation des hier beispielhaft genannten Keramiksubstrat bestehen bleibt, was bisher eine möglichst gezielte formschlüssige mechanische Verbindung der thermisch relevanten gewölbten Oberfläche des Halbleiterelements mit den thermisch relevanten planen Oberfläche des Kühlkörpers eher verhindert.

Mittels einer gezielten Deformation der Kühlkörperoberfläche des Kühlkörpers, insbesondere für die Betriebszustände des Halbleiterelements mit einem hohen Bedarf an Entwärmung, kann eine verbesserte formschlüssige mechanische Verbindung der thermisch relevanten gewölbten Oberfläche des Halbleiterelements mit der thermisch relevanten Kühlkörperoberfläche des Kühlkörpers erzielt werden.

Für die Lösung der Aufgabe wird eine Halbleiterbaugruppe vorgeschlagen, welche ein Halbleiterelement mit ersten Kontakten, ein Trägerelement mit zweiten Kontakten und einen Kühlkörper umfasst, wobei die ersten Kontakte, angeordnet an einer dem Trägerelement zugewandten ersten Oberfläche des Halbleiterelements, mittels elektrisch leitfähigem Materials mit den zweiten Kontakten des Trägerelements elektrisch verbunden sind, wobei das Halbleiterelement an einer von der ersten Oberfläche entgegengesetzten zweiten Oberfläche eine konvexe Wölbung mit einem ersten Radius oder eine konkave Wölbung mit einem zweiten Radius aufweist, wobei das Halbleiterelement an der zweiten Oberfläche der konvexen Wölbung mit einer Kühlkörperoberfläche einer konkaven Kühlkörperwölbung des Kühlkörpers formschlüssig verbunden ist und im Betrieb bei einer ausgewählten Sperrschichttemperatur der erste Radius der konvexen Wölbung höchstens 10% von einem dritten Radius der konkaven Kühlkörperwölbung abweicht oder wobei das Halbleiterelement an der zweiten Oberfläche der konkaven Wölbung mit einer Kühlkörperoberfläche einer konvexen Kühlkörperwölbung des Kühlkörpers formschlüssig verbunden ist und im Betrieb bei einer ausgewählten Sperrschichttemperatur der zweite Radius der konkaven Wölbung höchstens 10% von einem vierten Radius der konvexen Kühlkörperwölbung abweicht.

Je nach Ausprägung der Art der Wölbung als konkave oder konvexe Wölbung der zweiten Oberfläche des Halbleiterelements ist der Kühlkörper an seiner Kühlkörperoberfläche in vorteilhafter Weise mit einer entsprechenden vorgefertigten konvexen oder konkaven Kühlkörperwölbung ausgebildet, welche beim Betrieb des Halbleiterelements mit der ausgewählten Sperrschichttemperatur, also insbesondere bei einem Betriebszustand, welcher eine bestmögliche Entwärmung des Halbleiterelements erfordert, eine höchstens 10%ig Abweichung der Radien der jeweiligen Wölbungen des Halbleiterelements von den Radien der jeweiligen Kühlkörperwölbungen bildet.

Diese Abweichung der genannten Radien ermöglicht auch einen indirekten Nachweis über die Güte der formschlüssigen Verbindung.

Die geringfügige Abweichung der genannten Radien von höchstens 10% bildet demnach in vorteilhafter Weise eine fast vollständige formschlüssige mechanisch/thermische Verbindung der zweiten Oberfläche des Halbleiterelements mit der für die Entwärmung des Halbleiterelements relevanten Kühlkörperoberfläche des Kühlkörpers.

Vorteilhafte Ausgestaltungsformen der Halbleiterbaugruppe sind in den abhängigen Ansprüchen angegeben.

Bei einer ersten vorteilhaften Ausgestaltungsform der Halbleiterbaugruppe ist das Halbleiterelement mit der ausgewählten Sperrschichttemperatur aus einem Wertebereich zwischen einschließlich 50% einer maximalen Sperrschichttemperatur des Halbleiterelements und der maximalen Sperrschichttemperatur des Halbleiterelements betreibbar.

Das Betreiben des Halbleiterelements mittels der ausgewählten Sperrschichttemperatur aus diesem Wertebereich deckt vorteilhaft die eigentlichen Betriebszustände des Halbleiterelements ab, für welche insbesondere ein zuverlässiger und effizienter Betrieb des Halbleiterelements sowie damit verbunden eine zuverlässige wie auch effiziente Entwärmung des Halbleiterelements erforderlich sind.

Bei einer weiteren vorteilhaften Ausgestaltungsform der Halbleiterbaugruppe ist ein erster thermischer Ausdehnungskoeffizient des Halbleiterelements kleiner als ein zweiter thermischer Ausdehnungskoeffizient des Trägerelements.

Bei dieser Ausgestaltungsform der Halbleiterbaugruppe ist an der zweiten Oberfläche des Halbleiterelements die konvexe Wölbung ausgebildet, welche in vorteilhafter Weise mit der Kühlkörperoberfläche der konkaven Kühlkörperwölbung des Kühlkörpers, je nach ausgewählter Sperrschichttemperatur innerhalb der 10%igen Abweichung des ersten Radius der konvexen Wölbungen des Halbleiterelements von dem dritten Radius der konkaven Kühlkörperwölbungen des Kühlkörpers, formschlüssig verbunden ist.

Bei einer weiteren vorteilhaften Ausgestaltungsform der Halbleiterbaugruppe sind Unebenheiten im Material der zweiten Oberfläche der konvexen Wölbung des Halbleiterelements und/oder der Kühlkörperoberfläche der konkaven Kühlkörperwölbung des Kühlkörpers durch ein wärmeleitendes Mittel ausgeglichen.

Die Unebenheiten im Material der zweiten Oberfläche der konvexen Wölbung des Halbleiterelements und/oder der Kühlkörperoberfläche der konkaven Kühlkörperwölbung des Kühlkörpers sind nicht vergleichbar mit Lücken in der mechanischen Verbindung zwischen der zweiten Oberfläche der konvexen Wölbung des Halbleiterelements und der Kühlkörperoberfläche der konkaven Kühlkörperwölbung des Kühlkörpers, welche auftreten, wenn eine formschlüssige Verbindung an den genannten Oberflächen großflächig und/oder punktuell nicht erzeugbar ist.

Als wärmeleitendes Material, welches die Unebenheiten im Material, insbesondere Poren in der Materialstruktur der Materialoberflächen, verschließen soll, kommen z.B. Öl oder vergleichbare wärmeleitfähige Materialien zum Einsatz, welche insbesondere in einem flüssigen Zustand sind.

Bei einer weiteren vorteilhaften Ausgestaltungsform der Halbleiterbaugruppe ist ein erster thermischer Ausdehnungskoeffizient des Halbleiterelements größer als ein zweiter thermischer Ausdehnungskoeffizient des Trägerelements.

Bei dieser Ausgestaltungsform der Halbleiterbaugruppe ist an der zweiten Oberfläche des Halbleiterelements die konkave Wölbung ausgebildet, welche in vorteilhafter Weise mit der Kühlkörperoberfläche der konvexen Kühlkörperwölbung des Kühlkörpers, je nach ausgewählter Sperrschichttemperatur innerhalb der 10%igen Abweichung des zweiten Radius der konkaven Wölbungen des Halbleiterelements von dem vierten Radius der konvexen Kühlkörperwölbungen des Kühlkörpers, formschlüssig verbunden ist.

Bei einer weiteren vorteilhaften Ausgestaltungsform der Halbleiterbaugruppe sind Unebenheiten im Material der zweiten Oberfläche der konkaven Wölbung des Halbleiterelements und/oder der Kühlkörperoberfläche der konvexen Kühlkörperwölbung des Kühlkörpers durch ein wärmeleitendes Mittel ausgeglichen.

Die Unebenheiten im Material der zweiten Oberfläche der konkaven Wölbung des Halbleiterelements und/oder der Kühlkörperoberfläche der konvexen Kühlkörperwölbung des Kühlkörpers sind nicht vergleichbar mit Lücken in der mechanischen Verbindung zwischen der zweiten Oberfläche der konkaven Wölbung des Halbleiterelements und der Kühlkörperoberfläche der konvexen Kühlkörperwölbung des Kühlkörpers, welche auftreten, wenn eine formschlüssige Verbindung an den genannten Oberflächen großflächig und/oder punktuell nicht erzeugbar ist.

Als wärmeleitendes Material, welches die Unebenheiten im Material, insbesondere Poren in der Materialstruktur der Materialoberflächen, verschließen soll, kommen z.B. Öl oder vergleichbare wärmeleitfähige Materialien zum Einsatz, welche insbesondere in einem flüssigen Zustand sind.

Für die Lösung der Aufgabe wird ebenfalls ein Umrichter mit einer erfindungsgemäßen Halbleiterbaugruppe vorgeschlagen, wobei der Umrichter mit einem elektrischen Netz und einer elektrischen Maschine elektrisch verbindbar ist und wobei die elektrische Maschine durch den Umrichter mittels elektrischer Energie aus dem elektrischen Netz betreibbar ist.

Für die Lösung der Aufgabe wird ferner ein Herstellungsverfahren zur Fertigung eines Kühlkörpers für eine erfindungsgemäße Halbleiterbaugruppe vorgeschlagen, welches die Verfahrensschritte umfasst:
- Erste Ermittlung eines ersten Radius einer konvexen Wölbung einer zweiten Oberfläche eines Halbleiterelements, aufweisend zumindest eine Umgebungstemperatur, oder Erste Ermittlung eines zweiten Radius einer konkaven Wölbung einer zweiten Oberfläche eines Halbleiterelements, aufweisend zumindest eine Umgebungstemperatur, wobei jeweils die zweite Oberfläche entgegengesetzt zu einer ersten Oberfläche des Halbleiterelements, welche einem mit dem Halbleiterelement elektrisch verbundenen Trägerelement zugewandt ist, angeordnet ist,
- Zweite Ermittlung des ersten Radius der konvexen Wölbung der zweiten Oberfläche des Halbleiterelements, betrieben bei einer ausgewählten Sperrschichttemperatur, oder Zweite Ermittlung des zweiten Radius der konkaven Wölbung der zweiten Oberfläche des Halbleiterelements, betrieben bei einer ausgewählten Sperrschichttemperatur,
- Vergleich des ersten Radius, ermittelt bei zumindest der Umgebungstemperatur, mit dem ersten Radius, ermittelt bei der ausgewählten Sperrschichttemperatur, oder Vergleich des zweiten Radius, ermittelt bei zumindest der Umgebungstemperatur, mit dem zweiten Radius, ermittelt bei der ausgewählten Sperrschichttemperatur, und
- Herstellung einer konkaven Kühlkörperwölbung einer Kühlkörperoberfläche des Kühlkörpers mit einem dritten Radius, welcher gleich dem ersten Radius bei der ausgewählten Sperrschichttemperatur ist, wenn der erste Radius bei zumindest der Umgebungstemperatur kleiner ist, als der erste Radius bei der ausgewählten Sperrschichttemperatur, oder Herstellung einer konvexen Kühlkörperwölbung einer Kühlkörperoberfläche des Kühlkörpers mit einem vierten Radius, welcher gleich dem zweiten Radius bei der ausgewählten Sperrschichttemperatur ist, wenn der zweite Radius bei zumindest der Umgebungstemperatur größer ist, als der zweite Radius bei der ausgewählten Sperrschichttemperatur.

Der Verfahrensschritt der ersten Ermittlung wird unter Bedingungen durchgeführt, bei denen das Trägerelement und das Halbleiterelement bereits elektrisch und somit auch mechanisch miteinander über deren Kontakte und ein elektrisch leitfähiges Material miteinander verbunden sind und das Halbleiterelement zumindest die Umgebungstemperatur angenommen hat.

Der erste Radius der konvexen Wölbung der zweiten Oberfläche des Halbleiterelements oder der zweite Radius der konkaven Wölbung der zweiten Oberfläche des Halbleiterelements wird somit ermittelt.

Für den Verfahrensschritt der zweiten Ermittlung wird das Halbleiterelement mit der ausgewählten Sperrschichttemperatur betrieben. Diese ausgewählte Sperrschichttemperatur wird nach den Erfordernissen betrieblicher Anwendungsszenarien des Halbleiterelements ausgewählt, also beispielsweise für eine Betriebsart ausgewählt, bei der das Halbleiterelement nahe seiner maximalen Belastbarkeit betrieben wird und/oder bei der das Halbleiterelement über seine gesamte Betriebsdauer hinweg überwiegend betrieben wird.

Das Halbleiterelement wird also mit der ausgewählten Sperrschichttemperatur betrieben, um nunmehr unter diesen Bedingungen den ersten Radius der konvexen Wölbung der zweiten Oberfläche des Halbleiterelements oder den zweiten Radius der konkaven Wölbung der zweiten Oberfläche des Halbleiterelements zu ermitteln.

Im Allgemeinen bedeutet das, dass die ausgewählte Sperrschichttemperatur je nach Halbleiterelement deutlich größer ist als die Umgebungstemperatur des Halbleiterelements.

Beim Verfahrensschritt des Vergleichs wird evaluiert, ob der ersten Radius, welcher unter den Bedingungen des zumindest die Umgebungstemperatur aufweisenden Halbleiterelements ermittelt wurde, größer oder kleiner ist als der erste Radius, welcher unter den Bedingungen des Betriebs des Halbleiterelements mit der ausgewählten Sperrschichttemperatur ermittelt wurde, oder ob der zweite Radius, welcher unter den Bedingungen des zumindest die Umgebungstemperatur aufweisenden Halbleiterelements ermittelt wurde, kleiner oder größer ist als der zweite Radius, welcher unter den Bedingungen des Betriebs des Halbleiterelements mit der ausgewählten Sperrschichttemperatur ermittelt wurde.

Für die Herstellung der konkaven Kühlkörperwölbung der Kühlkörperoberfläche des Kühlkörpers soll nun der dritte Radius der konkaven Kühlkörperwölbung gleich dem ersten Radius sein, welcher beim Betrieb des Halbleiterelements mit der ausgewählten Sperrschichttemperatur ermittelt wurde. Dazu wird geprüft, ob der erste Radius, welcher bei zumindest der Umgebungstemperatur ermittelt wurde, kleiner ist als der erste Radius, welcher bei der ausgewählten Sperrschichttemperatur ermittelt wurde, um die hier notwendige konkave Art der benötigten Kühlkörperwölbung der Kühlkörperoberfläche des Kühlkörpers zu prüfen.

Vergleichbar zur Herstellung der konkaven Kühlkörperwölbung der Kühlkörperoberfläche des Kühlkörpers ist die Vorgehensweise für die Herstellung der konvexen Kühlkörperwölbung der Kühlkörperoberfläche des Kühlkörpers, bei der der vierte Radius der konvexen Kühlkörperwölbung gleich dem zweiten Radius sein soll, welcher beim Betrieb des Halbleiterelements mit der ausgewählten Sperrschichttemperatur ermittelt wurde. Dazu wird geprüft, ob der zweite Radius, welcher bei zumindest der Umgebungstemperatur ermittelt wurde, größer ist als der zweite Radius, welcher bei der ausgewählten Sperrschichttemperatur ermittelt wurde, um ebenfalls die hier konvexe Art der benötigten Kühlkörperwölbung der Kühlkörperoberfläche des Kühlkörpers zu prüfen.

Die so in vorteilhafter Weise jeweils bestimmten konkaven oder konvexen Kühlkörperwölbung des Kühlkörpers können dann mittels Fräßen aber auch mittels 3D-Druck sowie vergleichbarer materialabtragenden oder materialauftragenden Technologien erzeugt werden.

Bei einer vorteilhaften Ausgestaltungsform des Herstellungsverfahrens ist beim Verfahrensschritt der ersten Ermittlung das Halbleiterelement in einem elektrisch betriebslosen Zustand.

Der betriebslose Zustand, in dem sich das Halbleiterelement bei dieser Ausgestaltungsform während des Verfahrensschritts der ersten Ermittlung befindet, unterstützt in vorteilhafter Weise jeweils die Ermittlung des ersten Radius der konvexen Wölbung oder die Ermittlung des zweiten Radius der konkaven Wölbung der zweiten Oberfläche des Halbleiterelements bei exakt der Umgebungstemperatur, da das Halbleiterelement hier bei der ersten Ermittlung nur die Umgebungstemperatur annehmen kann.

Bei einer vorteilhaften Ausgestaltungsform des Herstellungsverfahrens weist das Halbleiterelement beim Verfahrensschritt der ersten Ermittlung die Umgebungstemperatur im Bereich eines Wertes von größer 0°C bis 30°C auf.

Umgebungstemperaturen können auch Raumtemperaturen im industriellen Umfeld sein, welche im technischen Kontext durchaus auch Temperaturen zwischen größer 0°C bis zu 30°C beispielsweise für den Einsatz von Bauelementen in Umrichtern industrieller Anlagen oder für Produktionsräume zur Herstellung von Bauelementen für derartige Umrichter umfassen kann.

Bei einer weiteren vorteilhaften Ausgestaltungsform des Herstellungsverfahrens wird beim Verfahrensschritt der ersten Ermittlung das Halbleiterelement mit einer Sperrschichttemperatur von kleiner 50% einer maximalen Sperrschichttemperatur des Halbleiterelements elektrisch betrieben wird und bei höherer Sperrschichttemperatur als der Umgebungstemperatur in den Verfahrensschritten Vergleich und Herstellung die Umgebungstemperatur durch die dann höhere Sperrschichttemperatur ersetzt.

In diesem Anwendungsbeispiel kann das Halbleiterelement für den Verfahrensschritt der ersten Ermittlung auch mit einer Sperrschichttemperatur betrieben werden, welche in vorteilhafter Weise größer ist als die Umgebungstemperatur aber immer noch kleiner als die 50% der maximalen Sperrschichttemperatur des Halbleiterelements. So kann bei Bedarf (z.B. Umgebungstemperatur kleiner oder gleich 0°C) über die Umgebungstemperatur hinaus ebenfalls eine definierte Temperatur als Ersatz für die Umgebungstemperatur beim Verfahrensschritt der Erste Ermittlung erzeugt werden.

Bei einer weiteren vorteilhaften Ausgestaltungsform des Herstellungsverfahrens wird für den Verfahrensschritt der zweiten Ermittlung die ausgewählte Sperrschichttemperatur aus einem Wertebereich zwischen einschließlich 50% der maximalen Sperrschichttemperatur des Halbleiterelements und der maximalen Sperrschichttemperatur des Halbleiterelements bestimmt und das Halbleiterelement mit dieser ausgewählten Sperrschichttemperatur betrieben.

Das Betreiben des Halbleiterelements mittels der ausgewählten Sperrschichttemperatur aus diesem Wertebereich für den Verfahrensschritt der zweiten Ermittlung deckt in vorteilhafter Weise die späteren Betriebszustände des Halbleiterelements ab, welche einen zuverlässigen und effizienten Betrieb des Halbleiterelements ebenso wie eine zuverlässige und effiziente Entwärmung des Halbleiterelements erfordern.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:

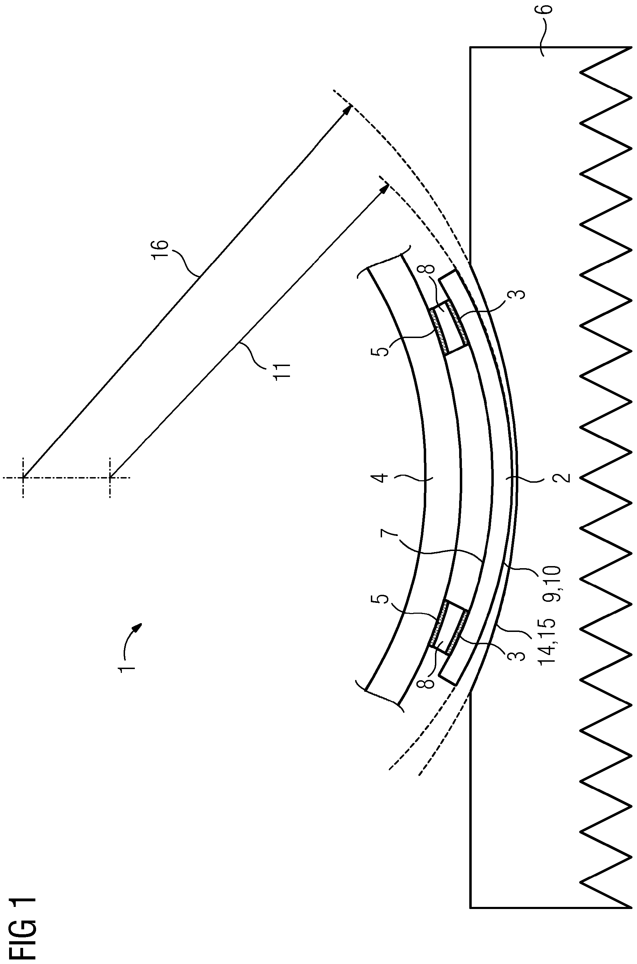

- FIG 1: eine schematische Darstellung einer erfindungsgemäßen Halbleiterbaugruppe mit einer Verbindung einer konvexen Wölbung eines Halbleiterelements der Halbleiterbaugruppe mit einer konkaven Kühlkörperwölbung eines Kühlkörpers der Halbleiterbaugruppe, wobei das Halbleiterelement beispielsweise zumindest eine Umgebungstemperatur aufweist und/oder sich in einem elektrisch betriebslosen Zustand befindet,

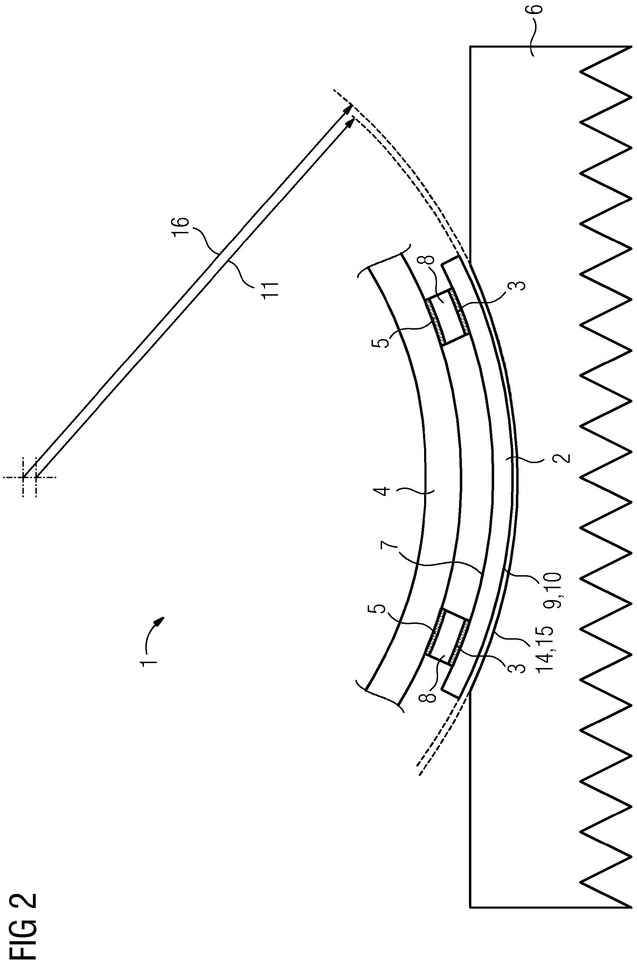

- FIG 2: eine zweite schematische Darstellung der erfindungsgemäßen Halbleiterbaugruppe nach FIG 1 mit einer Verbindung einer konvexen Wölbung des Halbleiterelements der Halbleiterbaugruppe mit der konkaven Kühlkörperwölbung des Kühlkörpers der Halbleiterbaugruppe, wobei das Halbleiterelement bei einer ausgewählten Sperrschichttemperatur betrieben wird,

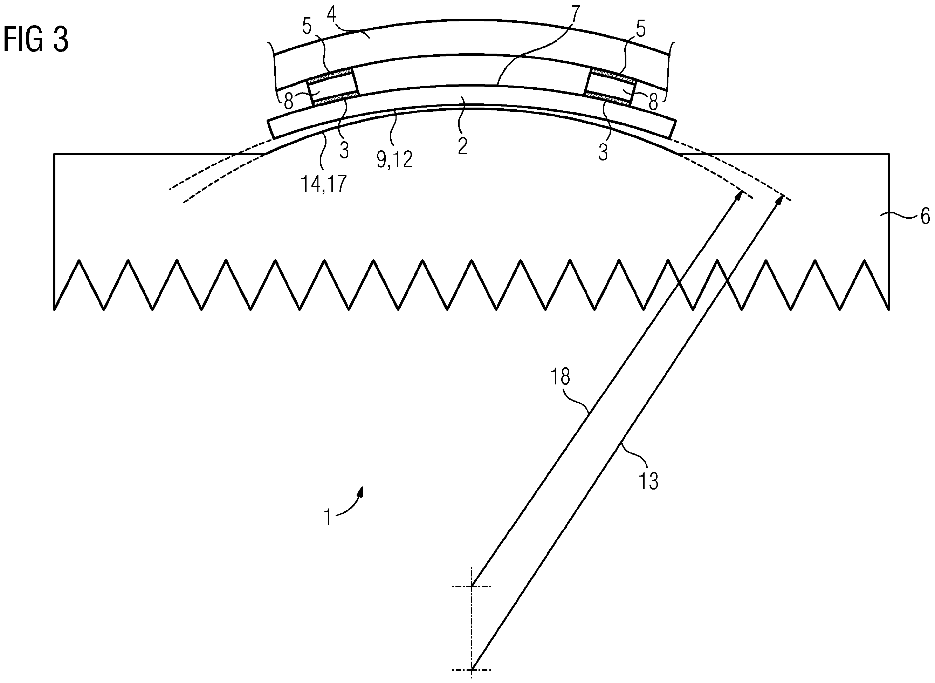

- FIG 3: eine weitere schematische Darstellung einer erfindungsgemäßen Halbleiterbaugruppe mit einer Verbindung einer konkaven Wölbung eines Halbleiterelements der Halbleiterbaugruppe mit einer konvexen Kühlkörperwölbung eines Kühlkörpers der Halbleiterbaugruppe, wobei das Halbleiterelement beispielsweise zumindest eine Umgebungstemperatur aufweist und/oder sich in einem elektrisch betriebslosen Zustand befindet,

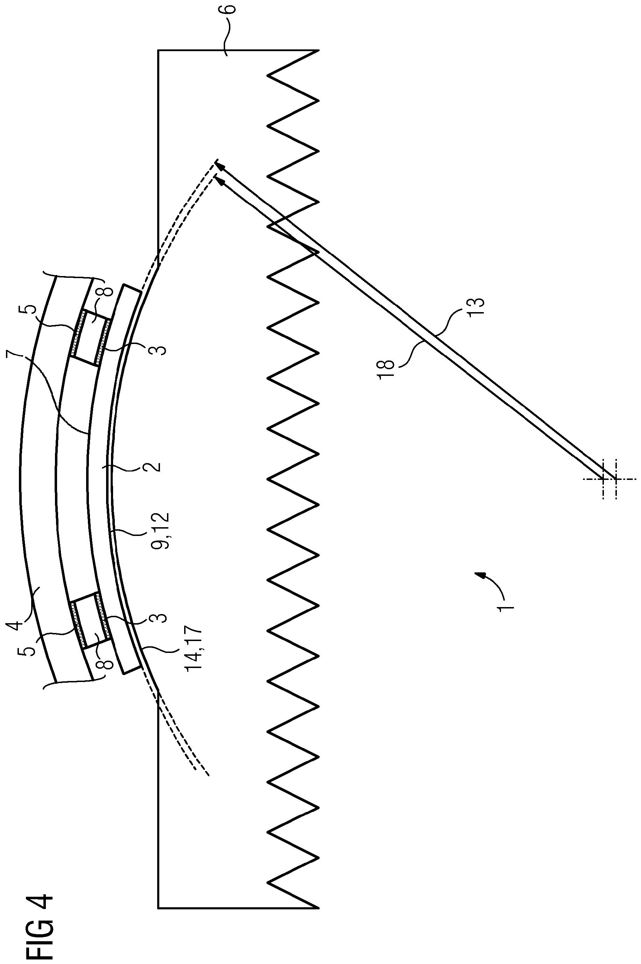

- FIG 4: eine zweite schematische Darstellung der erfindungsgemäßen Halbleiterbaugruppe nach FIG 3 mit einer mechanisch/thermischen Verbindung einer konkaven Wölbung des Halbleiterelements der Halbleiterbaugruppe mit der konvexen Kühlkörperwölbung des Kühlkörpers der Halbleiterbaugruppe, wobei das Halbleiterelement bei einer ausgewählten Sperrschichttemperatur betrieben wird,

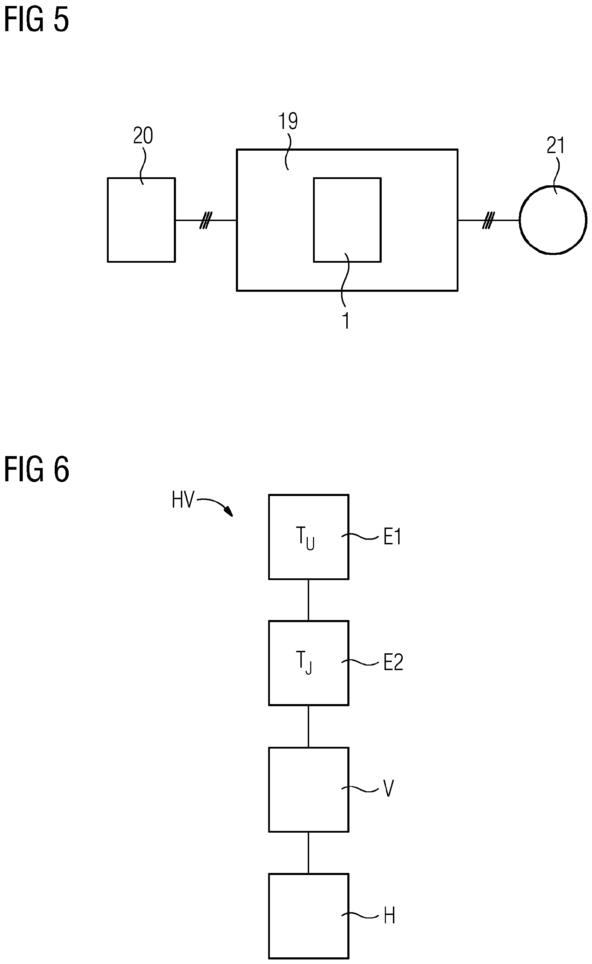

- FIG 5: ein schematisches Schaltbild eines Umrichters mit einer erfindungsgemäßen Halbleiterbaugruppe nach einer der Figuren 1 bis 4 und
- FIG 6: ein Struktogramm mit einem Herstellungsverfahren zur Fertigung eines Kühlkörpers für eine erfindungsgemäße Halbleiterbaugruppe nach einer der Figuren 1 bis 4.

Die FIG 1 zeigt eine schematische Darstellung einer erfindungsgemäßen Halbleiterbaugruppe 1 mit einer mechanisch/thermischen Verbindung (in FIG 1 aus zeichnerischen Gründen angedeutet) einer konvexen Wölbung 10 eines Halbleiterelements 2 der Halbleiterbaugruppe 1 mit einer konkaven Kühlkörperwölbung 15 eines Kühlkörpers 6 der Halbleiterbaugruppe 1, wobei das Halbleiterelement 2 beispielsweise zumindest eine Umgebungstemperatur aufweist und/oder sich in einem elektrisch betriebslosen Zustand befindet (beides in FIG 1 nicht explizit dargestellt).

Die Halbleiterbaugruppe 1 umfasst nach FIG 1 demnach das Halbleiterelement 2 mit ersten Kontakten 3, ein Trägerelement 4 mit zweiten Kontakten 5 und den Kühlkörper 6. Die ersten Kontakte 3, welche an einer dem Trägerelement 4 zugewandten ersten Oberfläche 7 des Halbleiterelements 2 angeordnet sind, verbinden das Halbleiterelement 2 elektrisch über ein elektrisch leitfähiges Material 8 mit den zweiten Kontakten 5 des Trägerelements 4.

Ferner zeigt die FIG 1 an der von der ersten Oberfläche 7 des Halbleiterelements 2 entgegengesetzten zweiten Oberfläche 9 des Halbleiterelements 2 die konvexe Wölbung 10 des Halbleiterelements 2 mit einem ersten Radius 11 sowie die an einer Kühlkörperoberfläche 14 des Kühlkörpers 6 konkave Kühlkörperwölbung 15 des Kühlkörpers 6 mit einem dritten Radius 16.

Die FIG 1 visualisiert hier in einer zeichnerisch überspitzten Weise deutlich die Wölbungen bzw. die Deformierungen des Halbleiterelements 2, des Trägerelements 4 sowie der Kühlkörperoberfläche 14 des Kühlkörpers 6. Diese Wölbungen sind tatsächlich eher sehr klein und befinden sich in der technischen Realität beispielsweis im Bereich von wenigen Mikrometern.

Ebenso deutlich ist in FIG 1 der Größenunterschied des ersten Radius 11 der konvexen Wölbung 10 der zweiten Oberfläche 9 des Halbleiterelements 2 im Vergleich zu dem dritten Radius 16 der konkaven Kühlkörperwölbung 15 der Kühlkörperoberfläche 14 des Kühlkörpers 6 dargestellt.

Eine gewünschte formschlüssige Verbindung der konvexen Wölbung 10 der zweiten Oberfläche 9 des Halbleiterelements 2 mit der konkaven Kühlkörperwölbung 15 der Kühlkörperoberfläche 14 des Kühlkörpers 6 ist in FIG 1 kaum bzw. nur punktuell vorhanden, was impliziert, dass das Halbleiterelement 2 der Halbleiterbaugruppe 1 beispielsweise elektrisch nicht im Betrieb ist und lediglich die Umgebungstemperatur aufweist oder beispielsweise nahe seiner Umgebungstemperatur mit einer geringen Sperrschichttemperatur kleiner 50% der maximalen Sperrschichttemperatur betrieben wird.

Mit der FIG 2 wird eine zweite schematische Darstellung der erfindungsgemäßen Halbleiterbaugruppe 1 nach FIG 1 mit einer mechanisch/thermischen Verbindung (in FIG 2 aus zeichnerischen Gründen angedeutet) einer konvexen Wölbung 10 des Halbleiterelements 2 der Halbleiterbaugruppe 1 mit der konkaven Kühlkörperwölbung 15 des Kühlkörpers 6 der Halbleiterbaugruppe 1 dargestellt, wobei das Halbleiterelement 2 bei einer ausgewählten Sperrschichttemperatur betrieben wird (in FIG 2 nicht explizit dargestellt).

Die Halbleiterbaugruppe 1 umfasst nach FIG 2, vergleichbar der FIG 1, das Halbleiterelement 2 mit ersten Kontakten 3, das Trägerelement 4 mit zweiten Kontakten 5 und den Kühlkörper 6. Die ersten Kontakte 3, welche an der dem Trägerelement 4 zugewandten ersten Oberfläche 7 des Halbleiterelements 2 angeordnet sind, verbinden das Halbleiterelement 2 elektrisch über das elektrisch leitfähige Material 8 mit den zweiten Kontakten 5 des Trägerelements 4.

Ferner zeigt auch FIG 2 an der von der ersten Oberfläche 7 des Halbleiterelements 2 entgegengesetzten zweiten Oberfläche 9 des Halbleiterelements 2 die konvexe Wölbung 10 des Halbleiterelements 2 mit dem ersten Radius 11 sowie die an einer Kühlkörperoberfläche 14 des Kühlkörpers 6 konkave Kühlkörperwölbung 15 des Kühlkörpers 6 mit dem dritten Radius 16.

Auch hier visualisiert die FIG 2 in einer zeichnerisch überspitzten Weise deutlich die Wölbungen bzw. die Deformierungen des Halbleiterelements 2, des Trägerelements 4 sowie der Kühlkörperoberfläche 14 des Kühlkörpers 6.

Ebenso deutlich geht jedoch aus der FIG 2 hervor, dass eine Abweichung des ersten Radius 11 der konvexen Wölbung 10 der zweiten Oberfläche 9 des Halbleiterelements 2 von dem dritten Radius 16 der konkaven Kühlkörperwölbung 15 der Kühlkörperoberfläche 14 des Kühlkörpers 6 in einem Bereich von höchstens 10% liegt.

Eine gewünschte formschlüssige Verbindung der konvexen Wölbung 10 der zweiten Oberfläche 9 des Halbleiterelements 2 mit der konkaven Kühlkörperwölbung 15 der Kühlkörperoberfläche 14 des Kühlkörpers 6 ist in FIG 2 demnach im Wesentlichen vorhanden, was impliziert, dass das Halbleiterelement 2 der Halbleiterbaugruppe 1 elektrisch mit einer ausgewählten Sperrschichttemperatur betrieben wird, welche in einem Bereich zwischen 50% der maximalen Sperrschichttemperatur und der maximalen Sperrschichttemperatur des Halbleiterelements 2 liegt.

Die FIG 3 zeigt eine weitere schematische Darstellung einer erfindungsgemäßen Halbleiterbaugruppe 1 jetzt mit einer mechanisch/thermischen Verbindung (in FIG 3 aus zeichnerischen Gründen angedeutet) einer konkaven Wölbung 12 eines Halbleiterelements 2 der Halbleiterbaugruppe 1 mit einer konvexen Kühlkörperwölbung 17 eines Kühlkörpers 6 der Halbleiterbaugruppe 1, wobei das Halbleiterelement 2 beispielsweise zumindest eine Umgebungstemperatur aufweist und/oder sich in einem elektrisch betriebslosen Zustand befindet (beides in FIG 3 nicht explizit dargestellt).

Die Halbleiterbaugruppe 1 umfasst nach FIG 3 demnach das Halbleiterelement 2 mit ersten Kontakten 3, ein Trägerelement 4 mit zweiten Kontakten 5 und den Kühlkörper 6. Die ersten Kontakte 3, welche an einer dem Trägerelement 4 zugewandten ersten Oberfläche 7 des Halbleiterelements 2 angeordnet sind, verbinden das Halbleiterelement 2 elektrisch über ein elektrisch leitfähiges Material 8 mit den zweiten Kontakten 5 des Trägerelements 4.

Ferner zeigt die FIG 3 an der von der ersten Oberfläche 7 des Halbleiterelements 2 entgegengesetzten zweiten Oberfläche 9 des Halbleiterelements 2 die konkave Wölbung 12 des Halbleiterelements 2 mit einem zweiten Radius 13 sowie die an einer Kühlkörperoberfläche 14 des Kühlkörpers 6 konvexe Kühlkörperwölbung 17 des Kühlkörpers 6 mit einem vierten Radius 18.

Die FIG 3 visualisiert hier in einer zeichnerisch überspitzten Weise deutlich die Wölbungen bzw. die Deformierungen des Halbleiterelements 2, des Trägerelements 4 sowie der Kühlkörperoberfläche 14 des Kühlkörpers 6.

Ebenso deutlich ist in FIG 3 der Größenunterschied des zweiten Radius 12 der konkaven Wölbung 12 der zweiten Oberfläche 9 des Halbleiterelements 2 im Vergleich zu dem vierten Radius 18 der konvexen Kühlkörperwölbung 17 der Kühlkörperoberfläche 14 des Kühlkörpers 6 dargestellt.

Eine gewünschte formschlüssige Verbindung der konkaven Wölbung 12 der zweiten Oberfläche 9 des Halbleiterelements 2 mit der konvexen Kühlkörperwölbung 17 der Kühlkörperoberfläche 14 des Kühlkörpers 6 ist in FIG 3 kaum bzw. nur punktuell vorhanden, was impliziert, dass das Halbleiterelement 2 der Halbleiterbaugruppe 1 beispielsweise elektrisch nicht im Betrieb ist und lediglich die Umgebungstemperatur aufweist oder beispielsweise nahe seiner Umgebungstemperatur mit einer geringen Sperrschichttemperatur kleiner 50% der maximalen Sperrschichttemperatur betrieben wird.

Mit der FIG 4 wird eine zweite schematische Darstellung der erfindungsgemäßen Halbleiterbaugruppe 1 nach FIG 3 mit einer mechanisch/thermischen Verbindung (in FIG 4 aus zeichnerischen Gründen angedeutet) einer konkaven Wölbung 12 des Halbleiterelements 2 der Halbleiterbaugruppe 1 mit der konvexen Kühlkörperwölbung 17 des Kühlkörpers 6 der Halbleiterbaugruppe 1 dargestellt, wobei das Halbleiterelement 2 bei einer ausgewählten Sperrschichttemperatur betrieben wird (in FIG 4 nicht explizit dargestellt).

Die Halbleiterbaugruppe 1 umfasst nach FIG 4, vergleichbar der FIG 3, das Halbleiterelement 2 mit ersten Kontakten 3, das Trägerelement 4 mit zweiten Kontakten 5 und den Kühlkörper 6. Die ersten Kontakte 3, welche an der dem Trägerelement 4 zugewandten ersten Oberfläche 7 des Halbleiterelements 2 angeordnet sind, verbinden das Halbleiterelement 2 elektrisch über das elektrisch leitfähige Material 8 mit den zweiten Kontakten 5 des Trägerelements 4.

Ferner zeigt auch FIG 4 an der von der ersten Oberfläche 7 des Halbleiterelements 2 entgegengesetzten zweiten Oberfläche 9 des Halbleiterelements 2 die konkave Wölbung 12 des Halbleiterelements 2 mit dem zweiten Radius 13 sowie die an einer Kühlkörperoberfläche 14 des Kühlkörpers 6 konvexe Kühlkörperwölbung 17 des Kühlkörpers 6 mit dem vierten Radius 18.

Auch hier visualisiert die FIG 4 in einer zeichnerisch überspitzten Weise deutlich die Wölbungen bzw. die Deformierungen des Halbleiterelements 2, des Trägerelements 4 sowie der Kühlkörperoberfläche 14 des Kühlkörpers 6.

Ebenso deutlich geht jedoch aus der FIG 4 hervor, dass eine Abweichung des zweiten Radius 13 der konkaven Wölbung 12 der zweiten Oberfläche 9 des Halbleiterelements 2 von dem vierten Radius 18 der konvexen Kühlkörperwölbung 17 der Kühlkörperoberfläche 14 des Kühlkörpers 6 in einem Bereich von höchstens 10% liegt.

Eine gewünschte formschlüssige Verbindung der konkaven Wölbung 12 der zweiten Oberfläche 9 des Halbleiterelements 2 mit der konvexen Kühlkörperwölbung 17 der Kühlkörperoberfläche 14 des Kühlkörpers 6 ist in FIG 4 demnach im Wesentlichen vorhanden, was impliziert, dass das Halbleiterelement 2 der Halbleiterbaugruppe 1 elektrisch mit einer ausgewählten Sperrschichttemperatur betrieben wird, welche in einem Bereich zwischen 50% der maximalen Sperrschichttemperatur und der maximalen Sperrschichttemperatur des Halbleiterelements 2 liegt.

Die FIG 5 zeigt ein schematisches Schaltbild eines Umrichters 19 mit einer erfindungsgemäßen Halbleiterbaugruppe 1 nach einer der Figuren 1 bis 4.

Der Umrichter 19 ist mit einem elektrischen Netz 20 und mit einer elektrischen Maschine 21 elektrisch verbunden. Die elektrische Verbindung ist in FIG 5 jeweils als dreiphasige Drehstromverbindung dargestellt. Im Betrieb des Umrichters 19 wird von dem elektrischen Netz 20 eine elektrische Energie bereitgestellt, mittels der der Umrichter 19 unter Einsatz der Halbleiterbaugruppe 1 die elektrische Maschine 21 betreibt.

Mit der FIG 6 wird ein Struktogramm mit einem Herstellungsverfahren HV zur Fertigung eines Kühlkörpers für eine erfindungsgemäße Halbleiterbaugruppe nach einer der Figuren 1 bis 4 aufgezeigt.

Das Herstellungsverfahren HV zur Fertigung des Kühlkörpers für die erfindungsgemäße Halbleiterbaugruppe umfasst die Verfahrensschritte erste Ermittlung E1, zweite Ermittlung E2, Vergleich V und Herstellung H.

Bei der ersten Ermittlung E1 wird der erster Radius der konvexen Wölbung der zweiten Oberfläche des Halbleiterelements, welches zumindest die Umgebungstemperatur T_{U} aufweist, oder der zweite Radius der konkaven Wölbung der zweiten Oberfläche des Halbleiterelements, welches zumindest die Umgebungstemperatur T_{U} aufweist, ermittelt. Dabei ist jeweils die zweite Oberfläche des Halbleiterelements entgegengesetzt zu der ersten Oberfläche des Halbleiterelements angeordnet, wobei die erste Oberfläche des Halbleiterelements dem mit ihr elektrisch verbundenen Trägerelement zugewandt ist.

Der Verfahrensschritt der ersten Ermittlung E1 wird unter Bedingungen durchgeführt, bei denen das Trägerelement und das Halbleiterelement bereits elektrisch und somit auch mechanisch miteinander über deren Kontakte und das elektrisch leitfähige Material miteinander verbunden sind und das Halbleiterelement zumindest die Umgebungstemperatur T_{U} angenommen hat.

Bei der zweiten Ermittlung E2 wird der erste Radius der konvexen Wölbung der zweiten Oberfläche des Halbleiterelements, welches bei einer ausgewählten Sperrschichttemperatur T_{J} betrieben wird, ermittelt oder wird der zweite Radius der konkaven Wölbung der zweiten Oberfläche des Halbleiterelements, welches bei einer ausgewählten Sperrschichttemperatur T_{J} betrieben wird, ermittelt.

Der Verfahrensschritt der zweiten Ermittlung E2 wird demzufolge unter Bedingungen durchgeführt, bei denen das Halbleiterelement mit der ausgewählten Sperrschichttemperatur T_{J} betrieben wird. Diese ausgewählte Sperrschichttemperatur T_{J} wird nach den Erfordernissen betrieblicher Anwendungsszenarien des Halbleiterelements ausgewählt, also beispielsweise für eine Betriebsart ausgewählt, bei der das Halbleiterelement nahe seiner maximalen Belastbarkeit betrieben wird und/oder bei der das Halbleiterelement über seine gesamte Betriebsdauer hinweg überwiegend betrieben wird.

Bei dem Vergleich V wird der erste Radius, ermittelt bei zumindest der Umgebungstemperatur T_{U}, mit dem ersten Radius, ermittelt bei der ausgewählten Sperrschichttemperatur T_{J}, verglichen oder der zweite Radius, ermittelt bei zumindest der Umgebungstemperatur T_{U}, mit dem zweiten Radius, ermittelt bei der ausgewählten Sperrschichttemperatur T_{J}, verglichen.

Beim Verfahrensschritt des Vergleichs V wird demnach evaluiert, ob der ersten Radius, welcher unter den Bedingungen des zumindest die Umgebungstemperatur T_{U} aufweisenden Halbleiterelements ermittelt wurde, größer oder kleiner ist, als der erste Radius, welcher unter den Bedingungen des Betriebs des Halbleiterelements mit der ausgewählten Sperrschichttemperatur T_{J} ermittelt wurde, oder ob der zweite Radius, welcher unter den Bedingungen des zumindest die Umgebungstemperatur T_{U} aufweisenden Halbleiterelements ermittelt wurde, kleiner oder größer ist, als der zweite Radius, welcher unter den Bedingungen des Betriebs des Halbleiterelements mit der ausgewählten Sperrschichttemperatur T_{J} ermittelt wurde.

Bei der Herstellung H der konkaven Kühlkörperwölbung der Kühlkörperoberfläche des Kühlkörpers mit dem dritten Radius ist dieser dritte Radius gleich dem ersten Radius bei der ausgewählten Sperrschichttemperatur T_{J}, wenn der erste Radius bei zumindest der Umgebungstemperatur T_{U} kleiner ist, als der erste Radius bei der ausgewählten Sperrschichttemperatur T_{J}.

Beim Verfahrensschritt der Herstellung H der konkaven Kühlkörperwölbung der Kühlkörperoberfläche des Kühlkörpers soll nun der dritte Radius der konkaven Kühlkörperwölbung gleich dem ersten Radius sein, welcher beim Betrieb des Halbleiterelements mit der ausgewählten Sperrschichttemperatur T_{J} ermittelt wurde. Dazu wird geprüft, ob der erste Radius, welcher bei zumindest der Umgebungstemperatur T_{U} ermittelt wurde, kleiner ist als der erste Radius, welcher bei der ausgewählten Sperrschichttemperatur T_{J} ermittelt wurde, um die hier notwendige konkave Art der benötigten Kühlkörperwölbung der Kühlkörperoberfläche des Kühlkörpers zu prüfen.

Bei der Herstellung H der konvexen Kühlkörperwölbung der Kühlkörperoberfläche des Kühlkörpers mit dem vierten Radius, ist dieser vierte Radius gleich dem zweiten Radius bei der ausgewählten Sperrschichttemperatur T_{J}, wenn der zweite Radius bei zumindest der Umgebungstemperatur T_{U} größer ist, als der zweite Radius bei der ausgewählten Sperrschichttemperatur T_{J}.

Vergleichbar zum Verfahrensschritt der Herstellung H der konkaven Kühlkörperwölbung der Kühlkörperoberfläche des Kühlkörpers soll nun beim Verfahrensschritt der Herstellung H der konvexen Kühlkörperwölbung der Kühlkörperoberfläche des Kühlkörpers der vierte Radius der konvexen Kühlkörperwölbung gleich dem zweiten Radius sein, welcher beim Betrieb des Halbleiterelements mit der ausgewählten Sperrschichttemperatur T_{J} ermittelt wurde. Dazu wird geprüft, ob der zweite Radius, welcher bei zumindest der Umgebungstemperatur T_{U} ermittelt wurde, größer ist als der zweite Radius, welcher bei der ausgewählten Sperrschichttemperatur T_{J} ermittelt wurde, um die hier notwendige konvexe Art der benötigten Kühlkörperwölbung der Kühlkörperoberfläche des Kühlkörpers zu prüfen.

## Patentansprüche

1. Halbleiterbaugruppe (1), umfassend ein Halbleiterelement (2) mit ersten Kontakten (3), ein Trägerelement (4) mit zweiten Kontakten (5) und einen Kühlkörper (6), wobei
- die ersten Kontakte (3), angeordnet an einer dem Trägerelement (4) zugewandten ersten Oberfläche (7) des Halbleiterelements (2), mittels elektrisch leitfähigem Materials (8) mit den zweiten Kontakten (5) des Trägerelements (4) elektrisch verbunden sind,
- das Halbleiterelement (2) an einer von der ersten Oberfläche (7) entgegengesetzten zweiten Oberfläche (9) eine konvexe Wölbung (10) mit einem ersten Radius (11) oder eine konkave Wölbung (12) mit einem zweiten Radius (13) aufweist,
- das Halbleiterelement (2) an der zweiten Oberfläche (9) der konvexen Wölbung (10) mit einer Kühlkörperoberfläche (14) einer konkaven Kühlkörperwölbung (15) des Kühlkörpers (6) formschlüssig verbunden ist und im Betrieb bei einer ausgewählten Sperrschichttemperatur (T_{J}) der erste Radius (11) der konvexen Wölbung (10) höchstens 10% von einem dritten Radius (16) der konkaven Kühlkörperwölbung (15) abweicht oder
- das Halbleiterelement (2) an der zweiten Oberfläche (9) der konkaven Wölbung (12) mit einer Kühlkörperoberfläche (14) einer konvexen Kühlkörperwölbung (17) des Kühlkörpers (6) formschlüssig verbunden ist und im Betrieb bei einer ausgewählten Sperrschichttemperatur (T_{J}) der zweite Radius (13) der konkaven Wölbung (12) höchstens 10% von einem vierten Radius (18) der konvexen Kühlkörperwölbung (17) abweicht.

2. Halbleiterbaugruppe (1) nach Anspruch 1, wobei das Halbleiterelement (2) mit der ausgewählten Sperrschichttemperatur (T_{J}) aus einem Wertebereich zwischen einschließlich 50% einer maximalen Sperrschichttemperatur des Halbleiterelements (2) und der maximalen Sperrschichttemperatur des Halbleiterelements (2) betreibbar ist.

3. Halbleiterbaugruppe (1) nach einem der Ansprüche 1 oder 2, wobei ein erster thermischer Ausdehnungskoeffizient des Halbleiterelements (2) kleiner als ein zweiter thermischer Ausdehnungskoeffizient des Trägerelements (4) ist.

4. Halbleiterbaugruppe (1) nach einem der vorhergehenden Ansprüche, wobei Unebenheiten im Material der zweiten Oberfläche (9) der konvexen Wölbung (10) des Halbleiterelements (2) und/oder der Kühlkörperoberfläche (14) der konkaven Kühlkörperwölbung (15) des Kühlkörpers (6) durch ein wärmeleitendes Mittel ausgeglichen sind.

5. Halbleiterbaugruppe (1) nach einem der Ansprüche 1 oder 2, wobei ein erster thermischer Ausdehnungskoeffizient des Halbleiterelements (2) größer als ein zweiter thermischer Ausdehnungskoeffizient des Trägerelements (4) ist.

6. Halbleiterbaugruppe (1) nach einem der Ansprüche 1, 2 oder 5, wobei Unebenheiten im Material der zweiten Oberfläche (9) der konkaven Wölbung (12) des Halbleiterelements (2) und/oder der Kühlkörperoberfläche (14) der konvexen Kühlkörperwölbung (17) des Kühlkörpers (6) durch ein wärmeleitendes Mittel ausgeglichen sind.

7. Umrichter (19) mit einer Halbleiterbaugruppe (1) nach einem der Ansprüche 1 bis 6, wobei der Umrichter (19) mit einem elektrischen Netz (20) und einer elektrischen Maschine (21) elektrisch verbindbar ist und wobei die elektrische Maschine (21) durch den Umrichter (19) mittels elektrischer Energie aus dem elektrischen Netz (20) betreibbar ist.

8. Herstellungsverfahren (HV) zur Fertigung eines Kühlkörpers (6) für eine Halbleiterbaugruppe (1) nach einem der Ansprüche 1 bis 6, umfassend die Verfahrensschritte:
- Erste Ermittlung (E1) eines ersten Radius (11) einer konvexen Wölbung (10) einer zweiten Oberfläche (9) eines Halbleiterelements (2), aufweisend zumindest eine Umgebungstemperatur (T_{U}), oder erste Ermittlung (E1) eines zweiten Radius (13) einer konkaven Wölbung (12) einer zweiten Oberfläche (9) eines Halbleiterelements (2), aufweisend zumindest eine Umgebungstemperatur (T_{U}), wobei jeweils die zweite Oberfläche (9) entgegengesetzt zu einer ersten Oberfläche (7) des Halbleiterelements (2), welche einem mit dem Halbleiterelement (2) elektrisch verbundenen Trägerelement (4) zugewandt ist, angeordnet ist,
- Zweite Ermittlung (E2) des ersten Radius (11) der konvexen Wölbung (10) der zweiten Oberfläche (9) des Halbleiterelements (2), betrieben bei einer ausgewählten Sperrschichttemperatur (T_{J}), oder zweite Ermittlung (E2) des zweiten Radius (13) der konkaven Wölbung (12) der zweiten Oberfläche (9) des Halbleiterelements (2), betrieben bei einer ausgewählten Sperrschichttemperatur (T_{J}),
- Vergleich (V) des ersten Radius (11), ermittelt bei zumindest der Umgebungstemperatur (T_{U}), mit dem ersten Radius (11), ermittelt bei der ausgewählten Sperrschichttemperatur (T_{J}), oder Vergleich (V) des zweiten Radius (13), ermittelt bei zumindest der Umgebungstemperatur (T_{U}), mit dem zweiten Radius (13), ermittelt bei der ausgewählten Sperrschichttemperatur (T_{J}) und
- Herstellung (H) einer konkaven Kühlkörperwölbung (15) einer Kühlkörperoberfläche (14) des Kühlkörpers (6) mit einem dritten Radius (16), welcher gleich dem ersten Radius (11) bei der ausgewählten Sperrschichttemperatur (T_{J}) ist, wenn der erste Radius (11) bei zumindest der Umgebungstemperatur (T_{U}) kleiner ist, als der erste Radius (11) bei der ausgewählten Sperrschichttemperatur (T_{J}), oder Herstellung (H) einer konvexen Kühlkörperwölbung (17) einer Kühlkörperoberfläche (14) des Kühlkörpers (6) mit einem vierten Radius (18), welcher gleich dem zweiten Radius (13) bei der ausgewählten Sperrschichttemperatur (T_{J}) ist, wenn der zweite Radius (13) bei zumindest der Umgebungstemperatur (T_{U}) größer ist, als der zweite Radius (13) bei der ausgewählten Sperrschichttemperatur (T_{J}) .

9. Herstellungsverfahren (HV) nach Anspruch 8, wobei beim Verfahrensschritt der ersten Ermittlung (E1) das Halbleiterelement (2) in einem elektrisch betriebslosen Zustand ist.

10. Herstellungsverfahren (HV) nach einem der Ansprüche 8 oder 9, wobei beim Verfahrensschritt der ersten Ermittlung (E1) das Halbleiterelement (2) die Umgebungstemperatur (T_{U}) im Bereich eines Wertes von größer 0°C bis 30°C aufweist.

11. Herstellungsverfahren (HV) nach Anspruch 8, wobei beim Verfahrensschritt der ersten Ermittlung (E1) das Halbleiterelement (2) mit einer Sperrschichttemperatur von kleiner 50% einer maximalen Sperrschichttemperatur des Halbleiterelements (2) elektrisch betrieben wird und bei höherer Sperrschichttemperatur als der Umgebungstemperatur (T_{U}) in den Verfahrensschritten Vergleich (V) und Herstellung (H) die Umgebungstemperatur (T_{U}) durch die dann höhere Sperrschichttemperatur ersetzt wird.

12. Herstellungsverfahren (HV) nach einem der Ansprüche 8 bis 11, wobei für den Verfahrensschritt der zweiten Ermittlung (E2) die ausgewählte Sperrschichttemperatur (T_{J}) aus einem Wertebereich zwischen einschließlich 50% der maximalen Sperrschichttemperatur des Halbleiterelements (2) und der maximalen Sperrschichttemperatur des Halbleiterelements (2) bestimmt wird und das Halbleiterelement (2) mit dieser ausgewählten Sperrschichttemperatur (T_{J}) betrieben wird.

## Claims

1. Semiconductor assembly (1), comprising a semiconductor element (2) with first contacts (3), a carrier element (4) with second contacts (5) and a cooling body (6), wherein
- the first contacts (3), arranged on a first surface (7), facing towards the carrier element (4), of the semiconductor element (2), are electrically connected by means of electrically conductive material (8) to the second contacts (5) of the carrier element (4),
- the semiconductor element (2) has, on a second surface (9) situated opposite the first surface (7), a convex curvature (10) with a first radius (11) or a concave curvature (12) with a second radius (13),
- the semiconductor element (2) is, on the second surface (9) of the convex curvature (10), connected in a positive-fit manner to a cooling body surface (14) of a concave cooling body curvature (15) of the cooling body (6) and, during operation at a selected barrier layer temperature (T_{J}), the first radius (11) of the convex curvature (10) deviates by at most 10% from a third radius (16) of the concave cooling body curvature (15) or
- the semiconductor element (2) is, on the second surface (9) of the concave curvature (12), connected in a positive-fit manner to a cooling body surface (14) of a convex cooling body curvature (17) of the cooling body (6) and, during operation at a selected barrier layer temperature (T_{J}), the second radius (13) of the concave curvature (12) deviates by at most 10% from a fourth radius (18) of the convex cooling body curvature (17) .

2. Semiconductor assembly (1) according to claim 1, wherein the semiconductor element (2) can be operated with the selected barrier layer temperature (T_{J}) from a range of values between 50% of a maximum barrier layer temperature of the semiconductor element (2) and the maximum barrier layer temperature of the semiconductor element (2) inclusive.

3. Semiconductor assembly (1) according to one of claims 1 or 2, wherein a first thermal expansion coefficient of the semiconductor element (2) is smaller than a second thermal expansion coefficient of the carrier element (4).

4. Semiconductor assembly (1) according to one of the preceding claims, wherein irregularities in the material of the second surface (9) of the convex curvature (10) of the semiconductor element (2) and/or the cooling body surface (14) of the concave cooling body curvature (15) of the cooling body (6) are smoothed out by heat-conducting means.

5. Semiconductor assembly (1) according to one of claims 1 or 2, wherein a first thermal expansion coefficient of the semiconductor element (2) is greater than a second thermal expansion coefficient of the carrier element (4).

6. Semiconductor assembly (1) according to one of claims 1, 2 or 5, wherein irregularities in the material of the second surface (9) of the concave curvature (12) of the semiconductor element (2) and/or the cooling body surface (14) of the convex cooling body curvature (17) of the cooling body (6) are smoothed out by heat-conducting means.

7. Inverter (19) having a semiconductor assembly (1) according to one of claims 1 to 6, wherein the inverter (19) can be electrically connected to an electrical network (20) and an electrical machine (21) and wherein the electrical machine (21) can be operated by the inverter (19) by means of electrical energy from the electrical network (20).

8. Production method (HV) for producing a cooling body (6) for a semiconductor assembly (1) according to one of claims 1 to 6, comprising the following method steps:
- First determination (E1) of a first radius (11) of a convex curvature (10) of a second surface (9) of a semiconductor element (2) having at least one ambient temperature (T_{U}), or first determination (E1) of a second radius (13) of a concave curvature (12) of a second surface (9) of a semiconductor element (2) having at least one ambient temperature (T_{U}), wherein in each case the second surface (9) is arranged opposite a first surface (7) of the semiconductor element (2) facing towards a carrier element (4) electrically connected to the semiconductor element (2),
- Second determination (E2) of the first radius (11) of the convex curvature (10) of the second surface (9) of the semiconductor element (2), operated at a selected barrier layer temperature (T_{J}), or second determination (E2) of the second radius (13) of the concave curvature (12) of the second surface (9) of the semiconductor element (2), operated at a selected barrier layer temperature (T_{J}),
- Comparison (V) of the first radius (11) determined at least at ambient temperature (T_{U}), with the first radius (11) determined at the selected barrier layer temperature (T_{J}), or comparison (V) of the second radius (13) determined at least at ambient temperature (T_{U}), with the second radius (13) determined at the selected barrier layer temperature (T_{J}) and
- Production (H) of a concave cooling body curvature (15) of a cooling body surface (14) of the cooling body (6) with a third radius (16) which is equal to the first radius (11) at the selected barrier layer temperature (T_{J}) when the first radius (11) at least at ambient temperature (T_{U}) is smaller than the first radius (11) at the selected barrier layer temperature (T_{J}), or production (H) of a convex cooling body curvature (17) of a cooling body surface (14) of the cooling body (6) with a fourth radius (18) which is equal to the second radius (13) at the selected barrier layer temperature (T_{U}) when the second radius (13) at least at ambient temperature (T_{U}) is greater than the second radius (13) at the selected barrier layer temperature (T_{J}).

9. Production method (HV) according to claim 8, wherein the semiconductor element (2) is in an electrically inoperative state during the first determination method step (E1).

10. Production method (HV) according to one of claims 8 or 9, wherein the semiconductor element (2) has the ambient temperature (T_{U}) in the range of a value of more than 0°C to 30°C during the first determination method step (E1).

11. Production method (HV) according to claim 8, wherein during the first determination method step (E1) the semiconductor element (2) is electrically operated at a barrier layer temperature of less than 50% of a maximum barrier layer temperature of the semiconductor element (2) and in the comparison (V) and production (H) method steps, at a higher barrier layer temperature than the ambient temperature (T_{U}), the ambient temperature (T_{U}) is replaced by the then higher barrier layer temperature.

12. Production method (HV) according to one of claims 8 to 11, wherein for the second determination method step (E2) the selected barrier layer temperature (T_{J}) is determined from a range of values between 50% of the maximum barrier layer temperature of the semiconductor element (2) and the maximum barrier layer temperature of the semiconductor element (2) inclusive and the semiconductor element (2) is operated at this selected barrier layer temperature (T_{J}).

## Revendications

1. Module (1) à semi-conducteur, comprenant un élément (2) semi-conducteur ayant des premiers contacts (3), un élément (4) support ayant des deuxièmes contacts (5) et un puits de chaleur (6), dans lequel
- les premiers contacts (3) disposés sur une première surface (7), tournée vers l'élément (4) de support, de l'élément (2) à semi-conducteur, sont reliés électriquement aux deuxièmes contacts (5) de l'élément (4) de support au moyen de matériau (8) conducteur de l'électricité,
- l'élément (2) semi-conducteur a sur une deuxième surface (9), opposée à la première surface (7), une courbure (10) convexe ayant un premier rayon (11) ou une courbure (12) concave ayant un deuxième rayon (13),
- l'élément (2) semi-conducteur est relié sur la deuxième surface (9) de la courbure (10) convexe à complémentarité de forme avec une surface (14) d'une courbure (15) concave du puits de chaleur (6) et, en fonctionnement, pour une température (T_{J}) de couche d'arrêt sélectionnée, le premier rayon (11) de la courbure (10) convexe s'écarte de 10% au plus d'un troisième rayon (16) de la courbure (15) convexe du puits de chaleur ou
- l'élément (2) semi-conducteur est relié sur la deuxième surface (9) de la courbure (12) concave à complémentarité de forme avec une surface (14) d'une courbure (17) convexe du puits de chaleur (16) et, en fonctionnement, pour une température (T_{J}) de couche d'arrêt sélectionnée, le deuxième rayon (13) de la courbure (12) convexe s'écarte de 10 % au plus d'un quatrième rayon (18) de la courbure (17) convexe du puits de chaleur.

2. Module (1) à semi-conducteur suivant la revendication 1, dans lequel l'élément de semi-conducteur peut à la température (T_{J}) de couche d'arrêt sélectionnée fonctionner dans une plage de valeurs comprise entre y compris 50% d'une température maximum de couche d'arrêt de l'élément (2) semi-conducteur et la température maximum de couche d'arrêt de l'élément (2) semi-conducteur.

3. Module (1) à semi-conducteur suivant l'une des revendications 1 ou 2, dans lequel un premier coefficient de dilatation thermique de l'élément (2) semi-conducteur est plus petit qu'un deuxième coefficient de dilatation thermique de l'élément (4) de support.

4. Module (1) à semi-conducteur suivant l'une des revendications précédentes, dans lequel des inégalités du matériau de la deuxième surface (9) de la courbure (10) convexe de l'élément (2) semi-conducteur et/ou de la surface (14) de la courbure (15) concave du puits de chaleur (6) sont compensées par un agent conducteur de la chaleur.

5. Module (1) à semi-conducteur suivant l'une des revendications 1 ou 2, dans lequel un premier coefficient de dilatation thermique de l'élément (2) semi-conducteur est plus grand qu'un deuxième coefficient de dilatation thermique de l'élément (4) de support.

6. Module (1) à semi-conducteur suivant l'une des revendications 1, 2 ou 5, dans lequel des inégalités du matériau de la deuxième surface (9) de la courbure (12) concave de l'élément (2) semi-conducteur et/ou de la surface (14) de la courbure (17) convexe du puits de chaleur (6) sont compensées par un agent conducteur de la chaleur.

7. Onduleur (19) ayant un module (1) à semi-conducteur suivant l'une des revendications 1 à 6, dans lequel l'onduleur (19) peut être connecté électriquement à un réseau (20) électrique et à une machine (21) électrique et dans lequel la machine (21) électrique peut fonctionner par l'onduleur (19) au moyen de l'énergie électrique du réseau (20) électrique.

8. Procédé (HV) de fabrication d'un puits de chaleur (6) d'un module (1) à semi-conducteur suivant l'une des revendications 1 à 6, comprenant les stades de procédé :
- première détermination (E1) d'un premier rayon (11) d'une courbure (10) convexe d'une deuxième surface (9) d'un élément (2) semi-conducteur, ayant au moins une température (T_{U}) ambiante, ou première détermination (E1) d'un deuxième rayon (13) d'une courbure (12) concave d'une deuxième surface (9) d'un élément (2) semi-conducteur ayant au moins une température (T_{U}) ambiante, dans lequel respectivement la deuxième surface (9) est disposée à l'opposé d'une première surface (7) de l'élément (2) semi-conducteur, qui est tournée vers un élément (4) de support relié électriquement à l'élément (2) semi-conducteur,
- deuxième détermination (E2) du premier rayon (11) de la courbure (10) convexe de la deuxième surface (9) de l'élément (2) semi-conducteur, en fonctionnement à une température (T_{J}) de couche d'arrêt sélectionnée, ou deuxième détermination (E2) du deuxième rayon (13) de la courbure (12) concave de la deuxième surface (9) de l'élément (2) semi-conducteur, en fonctionnement à une température (T_{J}) de couche d'arrêt sélectionnée,
- comparaison (V) du premier rayon (11), déterminé à au moins la température (T_{U}) ambiante, au premier rayon (11) déterminé à la température (T_{J}) de couche d'arrêt sélectionnée, ou comparaison (V) du deuxième rayon (13), déterminé à au moins la température (T_{U}) ambiante, au deuxième rayon (13), déterminé à la température (T_{J}) de couche d'arrêt sélectionnée et
- production (H) d'une courbure (15) concave d'une surface (14) du puits de chaleur (16) à un troisième rayon (16), qui est égal au premier rayon (11) à la température (T_{J}) de couche d'arrêt sélectionnée, si le premier rayon (11) est au moins à la température (T_{U}) ambiante plus petit que le premier rayon (11) à la température (T_{J}) de couche d'arrêt sélectionné, ou production (H) d'une courbure (17) convexe d'une surface (14) du puits de chaleur (6) à un quatrième rayon (18), qui est égal au deuxième rayon (13) à la température (T_{J}) de couche d'arrêt sélectionnée, si le deuxième rayon (13) est à au moins la température (T_{U}) ambiante plus grand que le deuxième rayon (13) à la température (T_{J}) de couche d'arrêt sélectionnée.

9. Procédé (HV) de production suivant la revendication 8, dans lequel dans le stade de procédé de la première détermination (E1) l'élément (2) semi-conducteur est dans un état sans fonctionnement électriquement.

10. Procédé (HV) de production suivant l'une des revendications 8 ou 9, dans lequel, au stade de procédé de la première détermination (E1), l'élément (2) semi-conducteur a la température (T_{U}) ambiante dans la plage d'une valeur de plus de 0°C à 30°C.

11. Procédé (HV) de production suivant la revendication 8, dans lequel, au stade du procédé de la première détermination (E1), on fait fonctionner électriquement l'élément (2) semi-conducteur à une température de couche d'arrêt plus petite que 50% d'une température de couche d'arrêt maximum de l'élément (2) semi-conducteur et, à une température de couche d'arrêt plus haute que la température (T_{U}) ambiante, dans les stades de procédé de comparaison (V) et de production (H), on remplace la température (T_{U}) ambiante par la température de couche d'arrêt alors plus haute.

12. Procédé (HV) de production suivant l'une des revendications 8 à 11, dans lequel, pour le stade de procédé de la deuxième détermination (E2), on détermine la température (T_{J}) de couche d'arrêt sélectionnée dans une plage de valeurs entre y compris 50% de la température de couche d'arrêt maximum de l'élément (2) semi-conducteur et la température de couche d'arrêt maximum de l'élément (2) semi-conducteur et en ce que l'on fait fonctionner l'élément (2) semi-conducteur à cette température (T_{J}) de couche d'arrêt sélectionnée.
